# EUROPEAN PATENT APPLICATION

(11) **EP 1 887 691 A1**
(43) Date of publication of application: **13.02.2008**
(21) Application number: 06118326.5
(22) Date of filing: 02.08.2006
(51) Int. Cl.: H03H 9/215, H03H 9/21

(54) **Piezoelectric resonator with short-circuits preventing means**

(71) Applicant: ETA SA Manufacture Horlogère Suisse, 2540 Grenchen (CH)
(72) Inventor: Dalla Piazza, Silvio, 2610 St-Imier (CH)
(74) Representative: Vigand, Philippe

(57) **Abstract**

The tuning fork piezoelectric resonator (1) according to the invention comprises a base part (4) from which protrudes first and second parallel vibrating arms (2, 3) carrying a set of excitation electrodes (5, 6) to make them vibrate, the set of excitation electrodes being formed by conductive deposits and comprising central electrodes (6a, 6b) on opposite main surfaces (9a, 9b) and lateral electrodes (5a, 5b) covering lateral surfaces (10a, 10b) of each vibrating arm, the central electrodes of the first arm and the lateral electrodes of the second arm being connected to a first pole of an excitation source and the lateral electrodes of the first arm and the central electrodes of the second arm being connected to a second pole of the excitation source, wherein on each vibrating arm, the conductive deposits forming the central electrodes and lateral electrodes are made for the ones with an oxidizable metal and for the others with an unoxidizable metal or conversely.

## Description

### FIELD OF INVENTION

The present invention concerns piezoelectric resonators and more particularly resonators of small dimensions which are most often used for making frequency generators in particular for portable electronic equipment, in numerous fields such as horology, information technology, telecommunications and the medical field.

### BACKGROUND OF THE INVENTION

Such a resonator of small dimensions has been disclosed in the prior art document US 4,384,232, which is enclosed herewith by way of reference. This document discloses a tuning fork resonator formed by a base and two vibrating arms protruding from the base. Each arm carries metallization which forms central electrodes on the opposite main surfaces and lateral electrodes along the edges of each arm. The central electrodes of one arm are connected to the lateral electrodes of the other arm and to one pole of the supply. The other central and lateral electrodes are similarly connected to the other pole of the supply. Electrodes are subjected to electric fields to make the arms vibrate.

The central and lateral electrodes are arranged with a fixed spacing there between so that these are not short-circuited one another. Nevertheless, this spacing is chosen as thin as possible in order to have better crystal impedance for the resonator. As a result, even if a small amount of dust falls between the central and lateral electrodes or if some gas is present in the vicinity of the electrodes, a short-circuit is likely to occur, and the vibration of the vibrating arms may then malfunction.

Some existing solutions of the prior art consist in providing a preventing short-circuit section formed between the central and lateral electrodes of each vibrating arm and arranged in the form of an insulating film that may be either located between the central and lateral electrodes or covering both the central and lateral electrodes. However, even if these prior solutions effectively prevents short-circuits between central and lateral electrodes, they further present several drawbacks, and in particular, they require to readapt the whole design of the resonator in order to keep the same characteristics such as resistance and crystal impedance of the resonator. This required design adaptations renders the making process more expensive which is not desirable for such mass product.

### SUMMARY OF THE INVENTION

The main goal of the present invention is to provide a tuning fork resonator having not only means for preventing short-circuit between the central and lateral electrodes on each vibrating arm but also a simple implementation of such means which does not disturb the resonator characteristics. For that purpose, the present invention relates to a tuning fork piezoelectric resonator comprising a base part from which protrudes first and second parallel vibrating arms carrying a set of excitation electrodes to make them vibrate, said set of excitation electrodes being formed by conductive deposits and comprising central electrodes on opposite main surfaces and lateral electrodes covering lateral surfaces of each vibrating arm, said central electrodes of said first arm and said lateral electrodes of said second arm being connected to a first pole of an excitation source and said lateral electrodes of said first arm and said central electrodes of said second arm being connected to a second pole of said excitation source, wherein on each vibrating arm, said conductive deposits forming the central electrodes and lateral electrodes are made for the ones with an oxidizable metal and for the others with an unoxidizable metal or conversely. Advantageous embodiments are defined in the dependent claims.

### BRIEF DESCRIPTION OF THE DRAWINGS

Other features and advantages of the invention will appear upon reading the following description which refers to the annexed drawings in which:

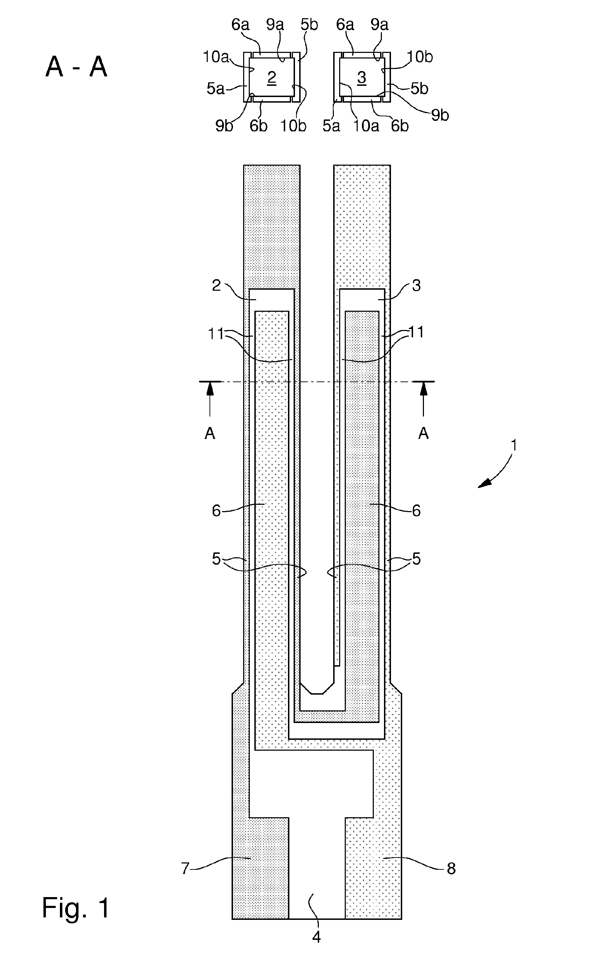

- Figure 1 represents a tuning fork resonator according to a preferred embodiment of the present invention.

### DETAILED DESCRIPTION OF THE INVENTION

The invention will described hereinafter by way of a non limiting example given in relation with Figure 1.

In a preferred embodiment shown in relation with Figure 1, the resonator, designated by the reference numeral 1, includes a tuning fork shaped part with two vibrating arms 2 and 3 joined by a base part 4, the whole assembly being made in a single piece of a piezoelectric material such as quartz. The base 4 and the arms 2 and 3 carry metallization, i.e. conductive deposits, which form, on the arms, a set of electrodes 5 and 6 which allow the arms to be subjected to electric fields to make them vibrate and, on base 4, connection pads 7 and 8 connected to the set of electrodes and relied to first and second pole of an excitation source or supply (not shown). Alternatively, connection pads 7 and 8 may be arranged on a third central arm (not shown) located between both vibrating arms 2 and 3.

As represented on the cut view A-A of Figure 1, each arm presents four faces, constituted by two opposite main surfaces 9a and 9b and two lateral surfaces 10a and 10b. The excitation electrodes are formed by conductive deposits and comprise central electrodes 6a and 6b on opposite main surfaces 9a and 9b and lateral electrodes 5a and 5b covering lateral surfaces 10a and 10b of each vibrating arm 2 and 3.

Very small spacing 11 is left between central 6a, 6b and lateral 5a, 5b electrodes in order to optimize the resonator behaviour. Nevertheless such small spacing or gap may be filled in by dust or gas; therefore central and lateral electrodes are short circuited one another. To prevent such short-circuit occurrence, on each vibrating arm, the conductive deposits forming the central electrodes and lateral electrodes are made for the ones with an oxidizable metal and for the others with an unoxidizable metal or conversely. Thus according to a preferred embodiment, central electrodes 6a and 6b of both arms 2 and 3 are made with an unoxidizable metal and lateral electrodes 5a and 5b of both arms 2 and 3 are made with an oxidizable metal.

Actually, in order to further simplify the making process of the resonator and more particularly deposit of the conductive metals, lateral electrodes 5a and 5b should preferably be made with an oxidizable metal. Nevertheless according to variants of the making process, it may also be possible to provide an oxidizable metal for the central electrodes and an unoxidizable metal for the lateral electrodes or alternatively to provide an oxidizable metal for the lateral electrodes of a first arm and for the central electrodes of the second arm, while providing an unoxidizable metal for the central electrodes of the first arm and for the lateral electrodes of the second arm.

The oxidizable metal may preferably be chosen among chrome, copper, aluminium, titanium and the unoxidizable metal may be chosen between silver and gold. Preferably, the central electrodes are formed by a tie layer, for example of chrome, coated by a metallic layer of an unoxidizable metal.

Having described the invention with regard to certain specific embodiments, it is to be understood that these embodiments are not meant as limitations of the invention. Indeed, various modifications, adaptations and/or combination between embodiments may become apparent to those skilled in the art without departing from the scope of the annexed claims. For instance, grooves may be cut along the longitudinal axis of each vibrating arm.

## Claims

1. A tuning fork piezoelectric resonator (1) comprising a base part (4) from which protrudes first and second parallel vibrating arms (2, 3) carrying a set of excitation electrodes (5, 6) to make them vibrate, said set of excitation electrodes being formed by conductive deposits and comprising central electrodes (6a, 6b) on opposite main surfaces (9a, 9b) and lateral electrodes (5a, 5b) covering lateral surfaces (10a, 10b) of each vibrating arm, said central electrodes of said first arm and said lateral electrodes of said second arm being connected to a first pole of an excitation source and said lateral electrodes of said first arm and said central electrodes of said second arm being connected to a second pole of said excitation source, wherein on each vibrating arm, said conductive deposits forming the central electrodes and lateral electrodes are made for the ones with an oxidizable metal and for the others with an unoxidizable metal or conversely.

2. The tuning fork piezoelectric resonator according to claim 1, wherein said lateral electrodes of both arms are made with an oxidizable metal and said central electrodes of both arms are made with an unoxidizable metal.

3. The tuning fork piezoelectric resonator according to claim 1, wherein said oxidizable metal is chosen among chrome, copper, aluminium, titanium.

4. The tuning fork piezoelectric resonator according to claim 1, wherein said unoxidizable metal is chosen between silver and gold.

5. The tuning fork piezoelectric resonator according to claim 4, wherein said central electrodes are formed by a tie layer coated by a metallic layer of said unoxidizable metal.
